# EUROPEAN PATENT SPECIFICATION

(11) **EP 2 436 723 B1**
(45) Date of publication and mention of the grant of the patent: **30.04.2014**
(21) Application number: 10780513.7
(22) Date of filing: 24.05.2010
(51) Int. Cl.: C08J 5/24, H05K 3/00

(54) **METHOD FOR MANUFACTURING PREPREG FOR PRINTED WIRING BOARD AND DEVICE FOR MANUFACTURING PREPREG FOR PRINTED WIRING BOARD**
VERFAHREN ZUR HERSTELLUNG EINES PREPREGS FÜR EINE BESTÜCKTE LEITERPLATTE SOWIE VORRICHTUNG ZUR HERSTELLUNG DES PREPREGS FÜR EINE BESTÜCKTE LEITERPLATTE
PROCÉDÉ DE FABRICATION D'UN PRÉ-IMPRIMÉ POUR CARTE DE CIRCUIT IMPRIMÉ ET DISPOSITIF DE FABRICATION D'UN PRÉ-IMPRIMÉ POUR CARTE DE CIRCUIT IMPRIMÉ

(30) Priority: 26.05.2009 JP 2009126133
(43) Date of publication of application: 04.04.2012
(73) Proprietor: Panasonic Corporation, Osaka 571-8501 (JP)
(72) Inventor: MATSUZAKI, Yoshinori, Osaka 540-6207 (JP); FUJITA, Kazuhiko, Otsu-shi Shiga 520-0842 (JP); TASHIRO, Masaya, Otsu-shi Shiga 520-0842 (JP); KOBAYASHI, Shinya, Otsu-shi Shiga 520-0842 (JP)
(74) Representative: Appelt, Christian W.
(86) International application number: PCT/JP2010/058748
(87) International publication number: WO 2010/137558

(56) References cited:
- GB-A- 2 086 444
- JP-A- 4 173 108
- JP-A- 4 193 506
- JP-A- 8 281 645
- JP-A- 11 268 037
- JP-A- 11 268 037
- JP-A- 2004 290 771
- JP-T- 9 512 495
- US-A1- 2009 126 974

## Description

### TECHNICAL FIELD

The present invention relates to a process of fabricating a prepreg for a printed circuit board by coating a substrate sheet made of glass fibers or the like with a resin fluid, and a device of fabricating a prepreg for a printed circuit board comprising equipment of coating a substrate sheet with a resin fluid.

### BACKGROUND ART

In the past, a dip and squeeze coating process and a dip and comma knife coating process are well known as a process of fabricating a prepreg for a printed circuit board. Each of these processes includes steps of: impregnating a substrate sheet with a resin fluid obtained by dissolving an insulating resin; subsequently drying it to a semi-cured state; and scraping away an excess resin on a surface of the substrate sheet in order to adjust a thickness of a resin layer of a resultant prepreg. Accordingly, these processes can feed the substrate sheet at appropriate speed, and thereby fabricate a prepreg efficiently and continuously. However, in these processes, the opposite surfaces of the substrate sheet are coated simultaneously. Therefore, it is difficult to independently control thicknesses of respective resin layers on the opposite surfaces of the substrate sheet.

In contrast to the above processes, there is a process of fabricating a prepreg including the step of independently coating the opposite surfaces of the substrate sheet with the resin fluid. This process is known as a process of independently controlling thicknesses of resin layers of the resultant prepreg with high accuracy. According to this process, it is possible to adjust the individual thickness of the resin layer of each surface of the resultant prepreg. However, in contrast to the process of impregnating the substrate sheet with the resin fluid, coating the surfaces one by one is likely to cause insufficient impregnation of the resin fluid and remaining of air bubbles inside of the resin fluid. In consideration of the above insufficiency, various methods have been provided for improving the impregnation of the resin fluid.

JP 8-281645 A and JP 11-268037 A disclose a process for removing air bubbles from the resin fluid. According to this process, in the process of coating the opposite surfaces of the substrate sheet with the resin fluid, the substrate sheet is impregnated with the resin fluid while being heated. Therefore, a device used for implementing this process needs a heater for heating the substrate sheet in the process of coating the opposite surfaces of the substrate sheet with the fluid resin. Consequently, implementation of this process requires a complicated device.

GB 2 086 444 A relaszes to a process for the continuous production of prepreg sheets unidirectionally arranged in parallel which involves contacting a plurality of fiber bundles arranged unidirectionally in parallel with each other with a solvent and continuously taking up the individual fiber bundle units under tension over curved surfaces of spreader bodies, such as cylinders while in a wet state, thereby spreading out said fiber bundles over the curved surfaces by means of said tension and subsequently drying the thus-spread out fibers.

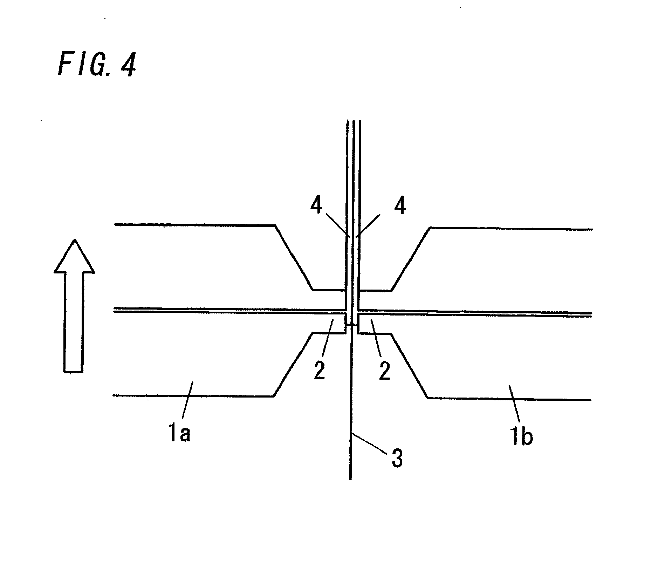

JP 2004-290771 A discloses a process including steps of: arranging coating heads 2 of two die coaters on opposite sides of the substrate sheet so as to be opposite to each other; and coating the opposite surfaces of the substrate sheet independently and simultaneously. FIG. 4 is a schematic cross sectional view illustrating a primary part of a device designed in such a manner as the prepreg fabricating device disclosed in reference document 3. In this device, with regard to a first dispenser 1a and a second dispenser 1b of the two die coaters, the coating heads 2 thereof are arranged to be opposite to each other such that a substrate sheet 3 is interposed between the coating heads 2. The coating heads 2 dispense the resin fluid to the opposite surfaces of the substrate sheet respectively, thereby coating the substrate sheet with the fluid resin. According to this process, the opposite surfaces of the substrate sheet are coated simultaneously, and implementation of this process does not require the means of heating the substrate sheet during the resin-coating on the opposite surface thereof. Consequently, in contrast to the prepreg fabricating devices of reference documents 1 and 2, the device according to reference document 3 can be simplified. Further, since the two coating heads 2 are opposite to each other and the opposite surfaces of the substrate sheet are coated with the fluid resins simultaneously, it is possible to remove air bubbles from the resin fluid and to improve impregnation of the resin fluid.

### SUMMARY OF INVENTION

However, according to the process of JP 2004-290771 A, in order to remove air bubbles from the substrate sheet 3, air bubbles should be transferred along an installation direction of the substrate sheet 3 which is opposite to the feeding direction thereof. In order to transfer air bubbles along the installation direction, the impregnation speed of a resin fluid 4 along the installation direction of the substrate sheet 3 should exceed the feeding speed of the substrate sheet 3. Therefore, unless the impregnation speed of the resin fluid 4 exceeds the feeding speed of the substrate sheet 3, air bubbles are not removed from the resin fluid 4 sufficiently. Thus, air bubbles remain inside of a resultant prepreg. In brief, sufficient removal of air bubbles from the resin fluid 4 requires slowing down the feeding speed of the substrate sheet 3 sufficiently, and the slowing down the feeding speed causes lowering the productivity of a prepreg.

In view of the above insufficiency, the present invention has been aimed to propose a process and a device of fabricating a prepreg for a printed circuit board which are capable of controlling respective thicknesses of resin layers on the opposite surfaces of a resultant prepreg, and of improving productivity, yet sufficiently removing air bubbles from the resultant prepreg.

The process recited in claim 1 is a process of fabricating a prepreg for a printed circuit board by resin-coating the opposite surfaces of an elongated substrate sheet 3. The process comprises the steps of: feeding the substrate sheet 3 while tensioning the same in a feeding direction along the length of the substrate sheet 3; bending the substrate sheet 3 at a first spot in the length thereof in a direction other than the feeding direction while dispensing and squeezing a resin fluid 4, at the first spot, on one surface of the substrate sheet 3 being bent for impregnating the substrate sheet 3 with the resin fluid 4; and subsequently bending the substrate sheet 3, at a second spot downstream of the first spot with regard to the feeding direction, in a direction other than the feeding direction while dispensing and squeezing a resin fluid 4, at the second spot, on the opposite surface of the substrate sheet 3 being thus bent for impregnating the substrate sheet 3 with the resin fluid 4.

The process of fabricating a prepreg for a printed circuit board recited in claim 2 includes the above steps, wherein the process employ a first dispenser 1a and a second dispenser 1b each of which is configured to have a coating head 2 extending in a width direction of the substrate sheet 3 for pressed contact with the substrate sheet 3 along its entire width, the coating head 2 being formed with a spout extending in the width direction of the substrate sheet 3 for dispensing the resin fluid 4 on the surface of the substrate sheet 3 being bent.

The process of fabricating a prepreg for a printed circuit board recited in claim 3 includes the above steps, wherein the process employs a first dispenser 1a and a second dispenser 1b each of which is in the form of a roller defining therearound a coating head 2 which is held in pressed contact with the substrate sheet 3 for transferring the resin fluid 4 from the periphery of the roller to the surface of the substrate sheet 3 as the roller rotates.

The device recited in claim 4 is a device of fabricating a prepreg for a printed circuit board by feeding an elongated substrate sheet 3 while tensioning the same in a feeding direction along the length of the substrate sheet 3, and resin-coating the opposite surfaces of the substrate sheet 3. The device includes: a first dispenser 1a configured to bend the substrate sheet 3 at a first spot in the length thereof in a direction other than the feeding direction while dispensing and squeezing a resin fluid 4, at the first spot, on one surface of the substrate sheet 3 being bent for impregnating the substrate sheet 3 with the resin fluid 4; and a second dispenser 1b configured to bend the substrate sheet 3, at a second spot downstream of the first spot with regard to the feeding direction, in a direction other than the feeding direction while dispensing and squeezing a resin fluid 4, at the second spot, on the opposite surface of the substrate sheet 3 being thus bent for impregnating the substrate sheet 3 with the resin fluid 4.

The device of fabricating a prepreg for a printed circuit board recited in claim 5 includes the above components, wherein each of the first dispenser 1a and the second dispenser 1b is a die coater.

The device of fabricating a prepreg for a printed circuit board recited in claim 6 includes the above components, wherein each of the first dispenser 1a and the second dispenser 1b is a roll coater.

According to the process of fabricating a prepreg for a printed circuit board recited in claim 1, continuous coating of the fluid resin on the opposite surfaces of the substrate sheet is made with the coating heads of the first dispenser and the second dispenser being pressed against the opposite surfaces of the substrate sheet respectively to bend it and coating the opposite surface. Such pressing enables to impregnate the resin fluid in the substrate sheet while squeezing out the bubbles in the resin fluid, thereby avoiding the bubbles from being entrapped in the prepreg. Further, the coating the resin fluid on the one surface of the substrate sheet is made while pressing the one surface to bend the substrate sheet, and subsequently the coating the resin fluid on the other surface of the substrate sheet is made while pressing the other surface to bend the substrate sheet. Therefore, in contrast to the simultaneous coating in which the substrate sheet is pressed simultaneously on the opposite surfaces, the above separate pressing is effective to successfully squeeze out the bubbles even when the substrate sheet is fed at a relatively high speed, and therefore enhance productivity with the high speed feeding. In addition, since the coating of the one surface of the substrate sheet is made separately from the other surface, it is possible to control the thickness of the resin fluid on the opposite surfaces of the substrate sheet independently from one another, facilitating to adjust the thickness of the resin layers of the prepreg.

According to the process of fabricating a prepreg for a printed circuit board recited in claim 2, the coating head is pressed onto the substrate sheet in a linear contact manner with regard to the width direction, the pressing force can be increased and thus air bubbles in the resin fluid can be successfully removed. Consequently, it can be successfully prevented that air bubbles are entrapped in the resultant prepreg. Besides, in the present invention, the situation where the coating head is contacted with the substrate sheet is defined to include a situation where the coating head is contacted with the substrate sheet directly, and also a situation where the coating head is contacted with the substrate sheet via the resin fluid. That is, the situation where the coating head is contacted with the substrate sheet includes a situation where the coating head gives pressing force to the substrate sheet through the resin fluid without being contacted with the substrate sheet directly and physically.

According to the process of fabricating a prepreg for a printed circuit board recited in claim 3, the coating head defined by the periphery of the roller is pressed onto the substrate sheet in a surface contact manner. Therefore, a region receiving the pressing force can be expanded and thus air bubbles in the resin fluid can be successfully removed. Consequently, it can be successfully prevented that air bubbles are entrapped in the resultant prepreg.

According to the device of fabricating a prepreg for a printed circuit board recited in claim 4, continuous coating of the fluid resin on the opposite surfaces of the substrate sheet is made with the coating heads of the first dispenser and the second dispenser being pressed against the opposite surfaces of the substrate sheet respectively to bend it and coating the opposite surfaces, respectively. Such pressing enables to impregnate the resin fluid in the substrate sheet while squeezing out the bubbles in the resin fluid, thereby avoiding the bubbles from being entrapped in the prepreg. Further, the coating the resin fluid on the one surface of the substrate sheet is made while pressing the one surface to bend the substrate sheet, and subsequently the coating the resin fluid on the other surface of the substrate sheet is made while pressing the other surface to bend the substrate sheet. Therefore, in contrast to the simultaneous coating in which the substrate sheet is pressed simultaneously on the opposite surfaces, the above separate pressing is effective to successfully squeeze out the bubbles even when the substrate sheet is fed at a relatively high speed, and therefore enhance productivity with the high speed feeding. In addition, since the coating of the one surface of the substrate sheet is made separately from the other surface, it is possible to control the thickness of the resin fluid on the opposite surfaces of the substrate sheet independently from one another, facilitating to adjust the thickness of the resin layers of the prepreg.

According to the device of fabricating a prepreg for a printed circuit board recited in claim 5, each of the first dispenser and the second dispenser is a die coater. Therefore, the coating head is designed to extend in the width direction of the substrate sheet for pressed contact with the substrate sheet along its entire width. Since the coating head is pressed onto the substrate sheet in a linear contact manner with regard to the width direction, the pressing force can be increased and thus air bubbles in the resin fluid can be successfully removed. Consequently, it can be successfully prevented that air bubbles are entrapped in the resultant prepreg.

According to the device of fabricating a prepreg for a printed circuit board recited in claim 6, each of the first dispenser and the second dispenser is a roll coater. Therefore, the coating head defined by the periphery of the roller is pressed onto the substrate sheet in a surface contact manner. Therefore, a region receiving the pressing force can be expanded and thus air bubbles in the resin fluid can be successfully removed. Consequently, it can be successfully prevented that air bubbles are entrapped in the resultant prepreg.

### BRIEF DESCRIPTION OF DRAWINGS

FIG. 1 is a schematic cross-sectional view illustrating a primary part of the embodiment of the process and the device of fabricating a prepreg for a printed circuit board of the present invention,
FIG. 2 is expanded cross-sectional views respectively illustrating different models in which the coating of the resin fluid dispensed from the first dispenser, wherein (a) illustrates the model corresponding to the present invention and both (b) and (c) illustrate the comparative models.
FIG.3 is a schematic cross-sectional view illustrating a primary part of another embodiment of the process and the device of fabricating a prepreg for a printed circuit board of the present invention, and
FIG. 4 is a schematic cross-sectional view illustrating a primary part of the process and the device of fabricating a prepreg of the prior art.

### DESCRIPTION OF EMBODIMENTS

### (FIRST EMBODIMENT)

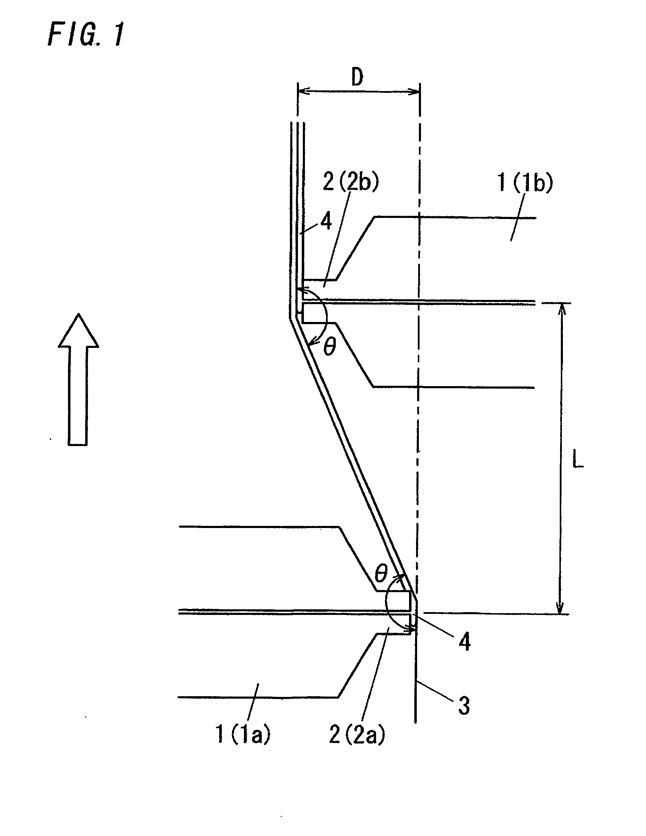

FIG. 1 shows an instance corresponding to a process and a device of fabricating a prepreg for a printed circuit board of the present invention. The device of fabricating a prepreg for a printed circuit board includes a first dispenser **1a** and a second dispenser **1b** each of which is a die coater. A substrate sheet 3 is fed along a direction of an illustrated arrow (a direction from lower to upper) in such a manner to pass between the two die coaters, and is coated with a resin fluid at its opposite surfaces one-by-one. Besides, in the present embodiment, the first dispenser **1a** and the second dispenser **1b** are die coaters of the same type, but may be die coaters of different types.

Each of the first dispenser **1a** and the second dispenser **1b** has a coating head **2**. The coating head **2** extends in a width direction of the substrate sheet **3** for pressed contact with the substrate sheet **3** along its entire width and is formed with a spout extending in the width direction of the substrate sheet for dispensing the resin fluid on the surface of the substrate sheet. A first coating head **2a** defined by the coating head **2** of the first dispenser **1a** extends to one surface of the substrate sheet **3**, and a second coating head **2b** defined by the coating head **2** of the second dispenser **1b** extends to the opposite surface of the substrate sheet **3**. In the process of dispensing the resin fluid **4**, the first coating head **2a** is held in pressed contact with the one surface of the substrate sheet 3 via the resin fluid **4**, and the second coating head **2b** is held in pressed contact with the opposite surface of the substrate sheet **3** via the fluid resin **4**.

The first dispenser **1a** and the second dispenser **1b** are arranged so as to dispense and squeeze the substrate sheet **3** with the resin fluid **4** not simultaneously but sequentially. The first coating head 2a and the second coating head **2b** are arranged so as to be spaced from each other by a distance L between dispensers in the feeding direction of the substrate sheet **3**. In view of projection of the two coating heads **2** in the feeding direction of the substrate sheet **3**, an apex of the first coating head **2a** is closer to a first spot of the substrate sheet **3** than an apex of the second coating head **2b**, and the apex of the second coating head **2b** is closer to a second spot of the substrate sheet **3** than the apex of the first coating head **2a**. Consequently, the first coating head **2a** and the second coating head **2b** are arranged to be overlapped with each other in a direction perpendicular to the length of the substrate sheet **3**. The distance between the apexes of the coating heads **2a** and **2b** in the direction perpendicular to the length of the substrate sheet is defined as a distance **D** between overlapped heads, and the distance **D** has a positive number when the heads **2a** and **2b** are overlapped with each other, and the distance **D** has a negative number when the heads **2a** and **2b** are not overlapped with each other.

The distance **L** between dispensers can be appropriately selected in consideration of materials of the substrate sheet **3** and the resin fluid **4**, and a feeding speed of the substrate sheet **3**. Preferably, the distance **L** between dispensers is in the range of 100 to 1000 mm, and more preferably in the range of 200 to 500 mm. When the distance **L** between dispensers is less than 100 mm, the distance between coating heads **2** is too short to bend the substrate sheet **3** and apply them to the substrate sheet **3** with enough pressure. In this instance, the pressing force applied to the substrate sheet is insufficient, and therefore it may fail to push out air bubbles from the resin fluid **4.** When the distance **L** between dispensers is greater than 1000 mm, the distance between coating heads **2** is too long to bend the substrate sheet **3** and apply them to the substrate sheet **3** with enough pressure. Also in this instance, the pressing force applied to the substrate sheet is insufficient, and therefore it may fail to push out air bubbles from the resin fluid **4**.

The distance **D** between overlapped heads can be appropriately selected for sufficiently bending the substrate sheet **3.** The distance D between overlapped heads is preferably in the range of 0 to 2000 µm and more preferably in the range of 1000 to 1200 µm. When the distance **D** between overlapped heads is less than 0 µm, it is impossible to bend the substrate sheet **3** and apply them to the substrate sheet **3** with enough pressure. In this instance, insufficient pressing force can be given, and therefore it may fail to push out air bubbles from the resin fluid **4**. When the distance D between overlapped heads is greater than 2000 µm, the pressure between the coating head and the substrate sheet is likely to increase excessively and thus prevent dispensing the resin fluid **4.** Besides, the substrate sheet **3** and two layers made of the fluid resin **4** are arranged within an overlap region between the first coating head **2a** and the second coating head **2b** in the direction perpendicular to the length of the substrate sheet **3**. Therefore, the two coating heads **2** are arranged in consideration of thicknesses of the substrate sheet **3** and the two layers made of the fluid resin **4.** Consequently, even when the distance **D** between overlapped heads is **0** µm, the substrate sheet **3** is kept being bent.

The resin fluid **4** may be appropriate one selected from resin fluids used for fabricating a prepreg for a printed circuit board. For example, such resin fluid is prepared by combining and mixing various thermoset resin (e.g., epoxy resin, polyimid resin, polyester resin, and phenol resin), a curing agent, a hardening accelerator, and a solvent.

The substrate sheet **3** may be appropriate one selected from substrate sheets for fabricating a prepreg for a printed circuit board. For example, such substrate sheet is inorganic fiber cloth including various glass cloth (e.g., roving cloth, cloth, a chopped mat, and a surfacing mat), metal fiber cloth, and the like; woven or unwove cloth made of liquid crystal fiber (e.g., wholly aromatic polyamide fiber, wholly aromatic polyester fiber, and polybenzazole fiber); woven or unwove cloth made of synthetic fiber (e.g., polyvinyl alcohol fiber, polyester fiber, and acrylic fiber); natural fiber cloth (e.g., cotton cloth, hemp cloth, and felt); carbon fiber cloth; and natural cellulosic cloth (e.g., craft paper, cotton paper, and paper-glass combined fiber paper).

In the process of coating the resin fluid **4** on the substrate sheet **3** while feeding the substrate sheet **3**, the feeding speed of the substrate sheet **3** is preferably in the range of 1 to 15 m/min, and more preferably in the range of **5** to 10 m/min. When the feeding speed of the substrate sheet **3** is less than 1 m/min, the productivity is likely to become poor. Meanwhile, when the feeding speed of the substrate sheet **3** is greater than 15 m/min, impregnation of the substrate sheet **3** with the resin fluid **4** may become insufficient. As described in the above, according to the present invention, even when the feeding speed of the substrate sheet **3** is as much fast as the speed (about 10 m/min) of a dip/squeeze method, it is enabled to remove air bubbles from the resin fluid **4**. Therefore, the productivity can be enhanced.

The first dispenser **1a** and the second dispenser **1b** may have the same discharge amount of the resin fluid per unit time, or may have the different discharge amounts of the resin fluid per unit time. The thickness of each of the layers of the resin fluid **4** on the opposite surfaces of the substrate sheet **3** can be controlled independently from each other by adjusting the respective discharge amounts of the resin fluid **4** per unit time. Therefore, it is easy to determine the respective thicknesses of the resin layers. The discharge amount per unit time may be selected appropriately. However, a ratio by weight of the discharge amount per unit time of the first dispenser 1a to the discharge amount per unit time of the second dispenser **1b** is preferably in the range of 40:60 to 80:20, and more preferably in the range of 60:40 to 70:30. When the discharge amount per unit time of the first dispenser **1a** is out of the above range and is less than the discharge amount per unit time of the second dispenser **1b**, the resin layer on the one surface is likely to have insufficient thickness. When the discharge amount per unit time of the second dispenser **1b** is out of the above range and is less than the discharge amount per unit time of the first dispenser **1a**, the resin layer on the opposite surface is likely to have insufficient thickness.

With the use of the above first and second dispensers **1a** and **1b**, continuous coating of the fluid resin **4** on the opposite surfaces of the substrate sheet **3** is made firstly with the first coating head **2a** being pressed against the one surface of the substrate sheet **3** to bend in one direction and coating the one surface, followed by the second coating head **2b** being pressed against the other surface of the substrate sheet **3** to bend in the other direction and coating the other surface. Such separate pressing enables to impregnate the resin fluid **4** in the substrate sheet **3** while squeezing out the bubbles in the resin fluid **4**, thereby avoiding the bubbles from being entrapped in the prepreg. In contrast to the simultaneous coating in which the substrate sheet is pressed simultaneously on the opposite surfaces, the above separate pressing is effective to successfully squeeze out the bubbles even when the substrate sheet **3** is fed at a relatively high speed, and therefore enhance productivity with the high speed feeding. In addition, since the coating of the one surface of the substrate sheet **3** is made separately from the other surface, it is possible to control the thickness of the resin fluid **4** on the opposite surfaces of the substrate sheet independently from one another, facilitating to adjust the thickness of the resin layers of the prepreg.

Further, in the present embodiment, since each of the first dispenser 1a and the second dispenser **1b** is a die coater, the coating head **2** is designed to extend in the width direction of the substrate sheet **3** for pressed contact with the substrate sheet **3** along its entire width. Since the coating head **2** is pressed onto the substrate sheet **3** in a linear contact manner with regard to the width direction, the pressing force can be increased and thus air bubbles can be successfully removed from the resin fluid **4.** Consequently, it can be successfully prevented that air bubbles are entrapped in the resultant prepreg.

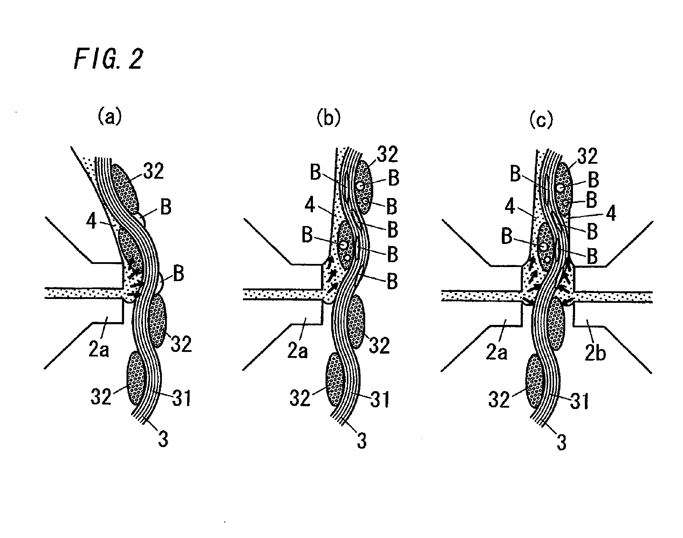

FIG. 2 shows expanded cross-sectional views respectively illustrating different models in which the coating of the fluid resin **4** dispensed from the first dispenser **1a**. In FIG. 2, (a) illustrates the process of the resin-coating corresponding to the process in accordance with the present invention. In FIG. 2, (b) illustrates the process of the resin-coating different from the present invention. In the process shown in (b), the substrate sheet **3** is not pressed. In FIG. 2, (c) illustrates the process of simultaneously coating the opposite surfaces of the substrate sheet **3** in a similar manner as the prior process shown in FIG. 4. In (c) of FIG. 2, the second coating head **2b** is disposed opposite of the substrate sheet 3 from the first coating head **2a.** Besides, the substrate sheet **3** illustrated in these models is composed of fibers 31 extending along the feeding direction and fibers **32** extending along the width direction.

As shown in (a) of FIG. 2, in the present invention, the coating head **2** dispenses the resin fluid **4** on the substrate sheet 3 while pressing the substrate sheet **3**. As illustrated by arrows, the injection pressure caused by dispensing the resin fluid 4 is almost applied to the substrate sheet **3** in its thickness direction. Therefore, the substrate sheet **3** is impregnated with resin fluid **4** while air bubbles **B** are pushed out from the resin fluid **4**. Consequently, no air bubbles B are entrapped in the substrate sheet **3**.

Meanwhile, in (b) of FIG. 2, the coating head **2** dispenses the resin fluid **4** on the substrate sheet 3 without pressing the substrate sheet **3.** As illustrated by arrows, the injection pressure caused by dispensing the resin fluid **4** is dispersed in directions substantially parallel to the one surface of the substrate sheet **3.** Accordingly, air bubbles **B** are not pushed out from the resin fluid **4.** Further, the insufficient impregnation can be obtained.

Further, in (c) of FIG. 2, the two coating heads **2** are arranged in a face-to-face manner, and dispense the resin fluid on the opposite surfaces of the substrate sheet **3** simultaneously, thereby pressing the substrate sheet on the opposite surfaces. Therefore, as illustrated by arrows, the injection pressure of the resin fluid **4** is applied to the substrate sheet **3** in its thickness direction. However, the feeding speed of the substrate **3** is faster than the speed in the feeding direction of the substrate **3** sheet of the resin fluid **4** dispensed. Therefore, the injection pressure is also dispersed in directions parallel to the feeding direction, and air bubbles B are not pushed out sufficiently. Accordingly, air bubbles **B** still exists inside of the substrate sheet **3**.

As described in the above, according to the process and the device of fabricating a prepreg of the present invention, high productivity can be given to the fabrication of the prepreg which is free from bubbles even at a high speed feeding, and has its opposite layers whose thickness can be adjusted independently.

### (SECOND EMBODIMENT)

In the first embodiment, the explanation is made to the instance employing die coaters as the first dispenser **1a** and the second dispenser **1b.** In the present embodiment, the explanation is made to the instance employing roll coaters as the first dispenser **1a** and the second dispenser **1b.**

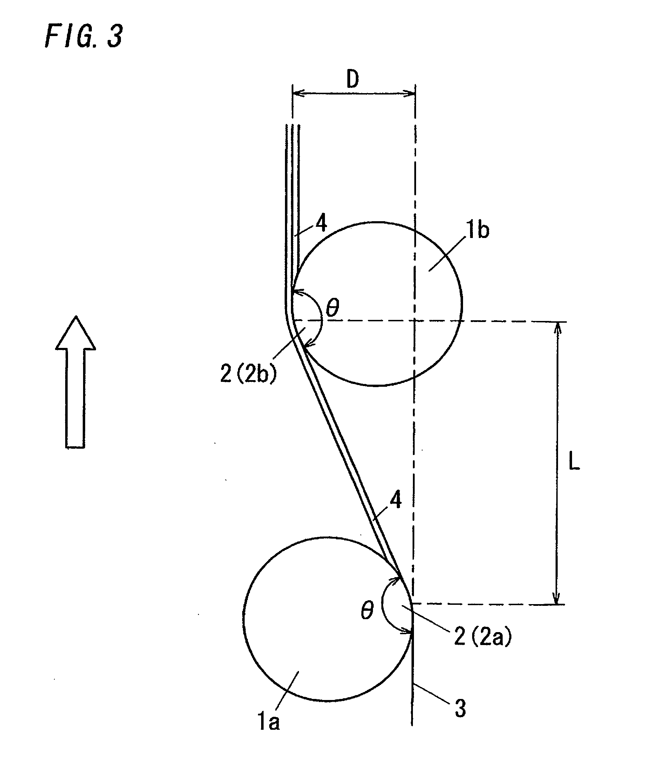

FIG. 3 shows a primary part of the process and the device of fabricating a prepreg for a printed circuit board on the present embodiment. In the present embodiment, the process employs the first dispenser **1a** and the second dispenser **1b** each of which is in the form of a roller defining therearound a coating head **2** which is held in pressed contact with the substrate sheet **3** for transferring the resin fluid **4** from the periphery of the roller to the surface of the substrate sheet **3** as the roller rotates. The first coating head **2a** and the second coating head **2b** are arranged to be spaced from each other by the distance **L** between dispensers in the feeding direction of the substrate sheet **3.** The first dispenser **1a** and the second dispenser **1b** are arranged so as to provide the distance **D** between overlapped heads defined by the distance of overlap between the two coating heads **2** in a direction perpendicular to the length of the substrate sheet **3.** The distance **L** between dispensers and the distance **D** between overlapped heads are selected appropriately in a similar manner as the first embodiment. The substrate sheet **3** and the resin fluid **4** of the first embodiment can be used as those of the present embodiment.

Also according to the present embodiment, with the use of the above first and second dispensers **1a** and **1b,** continuous coating of the fluid resin **4** on the opposite surfaces of the substrate sheet **3** is made firstly with the first coating head **2a** being pressed against the one surface of the substrate sheet **3** to bend in one direction and coating the one surface, followed by the second coating head **2b** being pressed against the other surface of the substrate sheet **3** to bend in the other direction and coating the other surface. Such separate pressing enables to impregnate the resin fluid **4** in the substrate sheet **3** while squeezing out the bubbles in the resin fluid **4**, thereby avoiding the bubbles from being entrapped in the prepreg. In contrast to the simultaneous coating in which the substrate sheet is pressed simultaneously on the opposite surfaces, the above separate pressing is effective to successfully squeeze out the bubbles even when the substrate sheet **3** is fed at a relatively high speed, and therefore enhance productivity with the high speed feeding. In addition, since the coating of the one surface of the substrate sheet **3** is made separately from the other surface, it is possible to control the thickness of the resin fluid **4** on the opposite surfaces of the substrate sheet independently from one another, facilitating to adjust the thickness of the resin layers of the prepreg.

In addition, in the present embodiment, since each of the first dispenser **1a** and the second dispenser **1b** is a roll coater, the coating head **2** defined by the periphery of the roller is pressed onto the substrate sheet **3** in a surface contact manner. Therefore, a region receiving the pressing force can be expanded and thus air bubbles can be successfully removed from the resin fluid **4.** Consequently, it can be successfully prevented that air bubbles remain inside of the resultant prepreg.

### [EXAMPLES]

Evaluation was made to prepregs respectively fabricated under plural conditions shown in table 1 by use of the prepreg fabricating device including the two dispensers **1** configured to perform resin-coating on the opposite surfaces of the substrate sheet **3** respectively. That is, the prepregs ware fabricated by coating the substrate sheet **3** with the resin fluid **4** under the plural conditions shown in the table 1: kind of the dispenser **1**, the distance **L** between dispensers, the distance **D** between overlapped heads, the feeding speed of the substrate sheet **3,** the line tension of feeding the substrate sheet **3**, and the ratio by weight per unit time of the injection amount of the first dispenser **1a** to the injection amount of the second dispenser **1b**. With regard to each prepreg, impregnation of the resin fluid **4** was evaluated and a ratio of thicknesses of resin layers of a prepreg was measured. Further, quality of a prepreg for a printed circuit board was checked based on comprehensive evaluation thereof.

With regard to the impregnation of the resin fluid **4,** evaluation is made according to the following criteria based on the number of the visually counted bubbles.

In table **1**, "poor" indicates that air bubbles exist, and "good" indicates that few air bubbles exist, and "excellent" indicates that no air bubbles exist.

With regard to the quality of the prepreg, evaluation is made according to the following criteria based on the comprehensive evaluation of the ratio of the thicknesses of the resin layers of the opposite surfaces and the impregnation of the resin fluid.

In table **1**, "poor" indicates that the prepreg is poor quality, and "good" indicates that the prepreg is good quality, and "excellent" indicates that the prepreg is excellent quality.

**[TABLE 1] TABLE 1**

| | Kind of dispenser | Feeding speed (m/min) | Distance L between dispensers (mm) | Distance D between overlapped heads (µm) | Line tension (kgf/m) (N/m) | Ratio of injection amounts ^{*1} (weight) | Resin impregnation | Ratio of resin thicknesses ^{*2} | Quality |
|---|---|---|---|---|---|---|---|---|---|
| Comparative example 1 | Die coater | 0.5 | 0 | -100 | 5₍₅₀₎ | 50:50 | good | 50:50 | good |
| Comparative example 2 | Die coater | 1.0 | 0 | -100 | 5₍₅₀₎ | 50:50 | poor | 50:50 | poor |
| Comparative example 3 | Roll coater | 1.0 | 0 | -100 | 5₍₅₀₎ | 50:50 | poor | 50:50 | poor |
| Example 1 | Die coater | 1.0 | 200 | 200 | 7₍₇₀₎ | 50:50 | excellent | 30:70 | good |
| Example 2 | Die coater | 1.0 | 200 | 200 | 7₍₇₀₎ | 65:35 | excellent | 50:50 | excellent |
| Example 3 | Die coater | 6.0 | 200 | 200 | 7₍₇₀₎ | 65:35 | good | 50:50 | good |
| Example 4 | Die coater | 5.0 | 200 | 1000 | 9₍₉₀₎ | 65:35 | excellent | 50:50 | excellent |
| Example 5 | Die coater | 10.0 | 200 | 1200 | 10₍₁₀₀₎ | 65:35 | excellent | 50:50 | excellent |
| Example 6 | Roll coater | 1.0 | 200 | 200 | 7₍₇₀₎ | 65:35 | excellent | 50:50 | excellent |
| Example 7 | Roll coater | 5.0 | 200 | 1000 | 9₍₉₀₎ | 65:35 | excellent | 50:50 | excellent |
| Example 8 | Roll coater | 10.0 | 200 | 1200 | 10₍₁₀₀₎ | 65:35 | excellent | 50:50 | excellent |

| | | | | | | | | | |
|---|---|---|---|---|---|---|---|---|---|
| *1) first dispenser : second dispenser *2) thickness of resin layer formed by the first dispenser : thickness of resin layer of second dispenser | | | | | | | | | |

Comparative examples **1** to 3 in table 1 were fabricated through a process of simultaneously dispensing the resin fluid to the opposite surfaces of the substrate sheet under the condition where the distance **L** between dispensers is 0 and the distance **D** between overlapped heads is less than 0 µm, as shown in FIG. 4. Meanwhile, examples **1** to 8 in table **1** were fabricated by a process of dispensing the resin fluid to the substrate sheet being bent by the coating head **2** under the condition where the distance **L** between the dispensers is greater than 0 and the distance **D** between overlapped heads is not less than 0 µm, as shown in FIG. 1 or 3.

Comparative examples 1 to 3 indicate that comparative example 1 exhibits good quality, and that an increase of the feeding speed of the substrate sheet **3** causes insufficient removal of air bubbles and lowers the quality as apparent from comparative examples 2 and 3. By contrast, as apparent from examples 1 to 8, even when the feeding speed of the substrate sheet **3** is increased, air bubbles are removed sufficiently, and a high-quality prepreg can be fabricated.
- 1: COATER
- 1a: FIRST DISPENSER
- 1b: SECOND DISPENSER
- 2: COATING HEAD
- 2a: FIRST COATING HEAD
- 2b: SECOND COATING HEAD
- 3: SUBSTRATE SHEET
- 4: RESIN FLUID
- L: DISPENSING DISTANCE BETWEEN DISPENSERS
- D: OVERLAP LENGTH BETWEEN HEADS

## Claims

1. A process of fabricating a prepreg for a printed circuit board by resin-coating the opposite surfaces of an elongated substrate sheet, said process comprising the steps of:
feeding said substrate sheet (3) while tensioning the same in a feeding direction along the length of said substrate sheet;
bending said substrate sheet (3) at a first spot in the length thereof in a direction other than a feeding direction while dispensing and squeezing a resin fluid (4) on one surface of said substrate sheet (3) being bent for impregnating said substrate sheet with said resin fluid; and
dispensing and squeezing a resin fluid (4) on the opposite surface of said substrate sheet for impregnating said substrate sheet with said resin fluid,
**characterized by**
subsequently bending said substrate sheet (3), at a second spot downstream of the first spot with regard to the feeding direction, in a direction other than the feeding direction; and in that
said resin fluid is dispensed and squeezed on said one surface of said substrate at the first spot, and
said resin fluid is dispensed and squeezed on said other surface of said substrate at the second spot, and
wherein the feeding speed of said substrate sheet (3) is in the range of 1 to 15 m/min.

2. The process as set forth in claim 1, wherein said process employ a first dispenser (1a) and a second dispenser (1b) each of which is configured to have a coating head (2a, 2b) extending in a width direction of said substrate sheet (3) for pressed contact with said substrate sheet along its entire width, said coating head (2a, 2b) being formed with a spout extending in the width direction of said substrate sheet for dispensing said resin fluid on said surface of the substrate sheet being bent.

3. The process as set forth in claim 1, wherein said process employs a first dispenser (1a) and a second dispenser (1b) each of which is in the form of a roller defining therearound a coating head which is held in pressed contact with said substrate sheet for transferring said resin fluid from a periphery of the roller to the surface of said substrate sheet as the roller rotates.

4. A device for fabricating a prepreg for a printed circuit board by feeding an elongated substrate sheet (3) while tensioning the same in a feeding direction along the length of said substrate sheet, and resin-coating the opposite surfaces of said substrate sheet, said device comprising:
a first dispenser (1a) configured to dispense and squeeze a resin fluid at a first spot on one surface of said substrate sheet for impregnating said substrate sheet with said resin fluid; and
a second dispenser (1b) configured to dispense and squeeze a resin fluid at a second spot, which is downstream of said first spot with regard to the feeding direction, on the opposite surface of said substrate sheet for impregnating said substrate sheet with said resin fluid;
**characterized in that**
the first dispenser (1a) is further adapted to bend said substrate sheet at the first spot in the length thereof in a direction other than a feeding direction, and
the second dispenser (1b) is further adapted to bend said substrate sheet at the second spot in a direction other than the feeding direction; and
wherein the feeding speed of said substrate sheet (3) is in the range of 1 to 15 m/min.

5. A device of fabricating a prepreg for a printed circuit board as set forth in claim 4, wherein each of said first dispenser and said second dispenser is a die coater.

6. A device of fabricating prepreg used for printed-wiring boards as set forth in claim 4, wherein each of said first dispenser and said second dispenser is a roll coater.

## Patentansprüche

1. Prozess zur Herstellung eines Prepregs für eine Leiterplatte durch Harzbeschichtung der gegenüberliegenden Oberflächen einer länglichen Substratlage, wobei der Prozess die folgenden Schritte umfasst:
Zuführen der Substratlage (3) unter Spannen selbiger in einer Zufuhrrichtung entlang der Länge der Substratlage;
Biegen der Substratlage (3) an einem ersten Punkt in der Länge davon in einer anderen Richtung als einer Zufuhrrichtung, während ein Harzfluid (4) auf einer Oberfläche der Substratlage (3), die gebogenen wird, verteilt und angepresst wird, um die Substratlage mit dem Harzfluid zu imprägnieren; und
Verteilen und Anpressen eines Harzfluids (4) auf der gegenüberliegenden Oberfläche der Substratlage, um die Substratlage mit dem Harzfluid zu imprägnieren,
**gekennzeichnet durch**
nachfolgendes Biegen der Substratlage (3) an einem zweiten Punkt hinter dem ersten Punkt bezüglich der Zufuhrrichtung in einer anderen Richtung als der Zufuhrrichtung; und dass
das Harzfluid auf der einen Oberfläche des Substrats an dem ersten Punkt verteilt und angepresst wird und
das Harzfluid auf der anderen Oberfläche des Substrats an dem zweiten Punkt verteilt und angepresst wird, und
wobei die Zufuhrgeschwindigkeit der Substratlage (3) im Bereich von 1 bis 15 m/min liegt.

2. Prozess nach Anspruch 1, wobei der Prozess einen ersten Verteiler (1a) und einen zweiten Verteiler (1b) verwendet, von denen jeder mit einem Beschichtungskopf (2a, 2b) aufweist, der sich in einer Breitenrichtung der Substratlage (3) für einen anpressenden Kontakt mit der Substratlage entlang ihrer ganzen Breite erstreckt, wobei der Beschichtungskopf (2a, 2b) mit einem Abfluss ausgebildet ist, der sich in der Breitenrichtung der Substratlage erstreckt, zum Verteilen des Harzfluids auf der Oberfläche der Substratlage, die gebogen wird.

3. Prozess nach Anspruch 1, wobei der Prozess einen ersten Verteiler (1a) und einen zweiten Verteiler (1b) verwendet, von denen jeder in der Form einer Walze vorliegt, die dort herum einen Beschichtungskopf definiert, der in einem angepressten Kontakt mit der Substratlage gehalten wird, zum Transferieren des Harzfluids von einer Peripherie der Walze zu der Oberfläche der Substratlage, während sich die Walze dreht.

4. Vorrichtung zur Herstellung eines Prepregs für eine Leiterplatte durch Zuführen einer länglichen Substratlage (3) unter Spannen selbiger in einer Zufuhrrichtung entlang der Länge der Substratlage und Harzbeschichtung der gegenüberliegenden Oberflächen der Substratlage, wobei die Vorrichtung Folgendes umfasst:
einen ersten Verteiler (1a), der konfiguriert ist zum Verteilen und Anpressen eines Harzfluids an einem ersten Punkt auf einer Oberfläche der Substratlage, um die Substratlage mit dem Harzfluid zu imprägnieren; und
einen zweiten Verteiler (1b), der konfiguriert ist zum Verteilen und Anpressen eines Harzfluids an einem zweiten Punkt, der sich bezüglich der Zufuhrrichtung hinter dem ersten Punkt befindet, auf der gegenüberliegenden Oberfläche der Substratlage, um die Substratlage mit dem Harzfluid zu imprägnieren;
**dadurch gekennzeichnet, dass**
der erste Verteiler (1a) weiterhin ausgelegt ist zum Biegen der Substratlage an dem ersten Punkt in der Länge davon in einer anderen Richtung als einer Zufuhrrichtung und
der zweite Verteiler (1b) weiterhin ausgelegt ist zum Biegen der Substratlage an dem zweiten Punkt in einer anderen Richtung als der Zufuhrrichtung; und
wobei die Zufuhrgeschwindigkeit der Substratlage (3) im Bereich von 1 bis 15 m/min liegt.

5. Vorrichtung zur Herstellung eines Prepregs für eine Leiterplatte nach Anspruch 4, wobei jeder des ersten Verteilers und des zweiten Verteilers ein Schmelzbeschichter ist.

6. Vorrichtung zur Herstellung eines Prepreg, der für Leiterplatten verwendet wird, nach Anspruch 4, wobei jeder des ersten Verteilers und des zweiten Verteilers ein Walzenbeschichter ist.

## Revendications

1. Procédé pour fabriquer un préimprégné pour carte de circuit imprimé par déposition d'une résine sous forme de revêtement sur les surfaces opposées d'une feuille de substrat allongée, ledit procédé comprenant les étapes consistant à :
charger ladite feuille de substrat (3) tout en tendant celle-ci dans la direction de chargement le long de la longueur de ladite feuille de substrat ;
plier ladite feuille de substrat (3) en un premier point de sa longueur dans une direction autre que la direction de chargement tout en délivrant et pressant une résine fluide (4) sur une surface de ladite feuille de substrat (3) qui est pliée pour imprégner ladite feuille de substrat avec ladite résine fluide ; et
délivrer et presser une résine fluide (4) sur la surface opposée de ladite feuille de substrat pour imprégner ladite feuille de substrat avec ladite résine fluide,
**caractérisé par**
le pliage subséquent de ladite feuille de substrat (3) en un deuxième point en aval du premier point en regard de la direction de chargement, dans une direction autre que la direction de chargement ; et en ce que
ladite résine fluide est délivrée et pressée sur ladite première surface dudit substrat au niveau du premier point, et
ladite résine fluide est délivrée et pressée sur ladite autre surface dudit substrat au niveau du deuxième point, et
dans lequel la vitesse de chargement de ladite feuille de substrat (3) est située dans la plage allant de 1 à 15 m/min.

2. Procédé selon la revendication 1, lequel procédé emploie un premier distributeur (1a) et un deuxième distributeur (1b), chacun étant configuré de façon à avoir une tête de revêtement (2a, 2b) s'étendant dans la direction de la largeur de ladite feuille de substrat (3) pour un contact par pressage avec ladite feuille de substrat le long de toute sa largeur, ladite tête de revêtement (2a, 2b) étant formée avec un bec verseur s'étendant dans la direction de la largeur de ladite feuille de substrat pour délivrer ladite résine fluide sur ladite surface de la feuille de substrat qui est pliée.

3. Procédé selon la revendication 1, lequel procédé emploie un premier distributeur (1a) et un deuxième distributeur (1b), chacun étant sous la forme d'un rouleau définissant autour de celui-ci une tête de revêtement qui est maintenue en contact pressé avec ladite feuille de substrat pour transférer ladite résine fluide depuis la périphérie du rouleau sur la surface de ladite feuille de substrat lorsque le rouleau tourne.

4. Dispositif pour fabriquer un préimprégné pour une carte de circuit imprimé par chargement d'une feuille de substrat (3) cependant que celle-ci est tendue dans la direction de chargement le long de la longueur de ladite feuille de substrat, et revêtement par une résine des surfaces opposées de ladite feuille de substrat, ledit dispositif comprenant :
un premier distributeur (1a) configuré pour délivrer et presser une résine fluide en un premier point sur une surface de ladite feuille de substrat de façon à imprégner ladite feuille de substrat avec ladite résine fluide ; et
un deuxième distributeur (1b) configuré pour délivrer et presser une résine fluide en un deuxième point, situé en aval dudit premier point en regard de la direction de chargement, sur la surface opposée de ladite feuille de substrat de façon à imprégner ladite feuille de substrat avec ladite résine fluide;
**caractérisé en ce que**
le premier distributeur (1a) est en outre adapté pour plier ladite feuille de substrat au niveau du premier point de sa longueur dans une direction autre que la direction de chargement, et
le deuxième distributeur (1b) est en outre adapté pour plier ladite feuille de substrat au niveau du deuxième point de sa longueur dans une direction autre que la direction de chargement ; et
dans lequel la vitesse de chargement de ladite feuille de substrat (3) est située dans la plage allant de 1 à 15 m/min.

5. Dispositif pour fabriquer un préimprégné pour une carte de circuit imprimé selon la revendication 4, dans lequel chacun dudit premier distributeur et dudit deuxième distributeur est une enduiseuse à filière.

6. Dispositif pour fabriquer un préimprégné pour une carte de circuit imprimé selon la revendication 4, dans lequel chacun dudit premier distributeur et dudit deuxième distributeur est une enduiseuse à rouleau.
